# EUROPÄISCHE PATENTSCHRIFT

(11) **EP 0 516 670 B1**
(45) Veröffentlichungstag und Bekanntmachung des Hinweises auf die Patenterteilung: **11.01.1995**
(21) Anmeldenummer: 91904170.7
(22) Anmeldetag: 19.02.1991
(51) Int. Cl.: C25D 5/00, C25D 17/00

(54) **VORRICHTUNG ZUM ABBLENDEN VON FELDLINIEN IN EINER GALVANIKANLAGE**
DEVICE FOR MASKING OFF THE FLUX LINES IN A GALVANIC BATH
DISPOSITIF D'ELIMINATION DES LIGNES DE CHAMP DANS UNE INSTALLATION DE GALVANISATION

(30) Priorität: 20.02.1990 DE 4005209
(43) Veröffentlichungstag der Anmeldung: 09.12.1992
(73) Patentinhaber: ATOTECH Deutschland GmbH, 10553 Berlin (DE)
(72) Erfinder: KAUPER, Rudolf, D-8501 Schwanstetten (DE); WILHELM, Gerhard, D-8501 Feucht (DE)
(74) Vertreter: Effert, Udo, Dipl.-Ing.
(86) Internationale Anmeldenummer: DE9100145
(87) Internationale Veröffentlichungsnummer: WO9113190

(56) Entgegenhaltungen:
- DE-C- 3 726 571
- US-A- 4 879 007

## Beschreibung

Die Erfindung betrifft eine Vorrichtung gemäß dem Oberbegriff des Anspruches 1. Dabei wird unter dem Ausdruck "im wesentlichen plattenförmigen Werkstücken" an zu galvanisierende Teile gedacht, die sich zwar überwiegend in einer Fläche ausdehnen, d.h. flächenhaften Charakter haben, jedoch aus dieser "Fläche" hervorragende Teile oder Abschnitte aufweisen können. In einer bevorzugten Ausführungsform ist an Leiterplatten gedacht, doch soll die Erfindung nicht auf die Behandlung solcher Platten beschränkt sein. Zur Behandlung von Leiterplatten ist es aus DE-PS 37 26 571 bekannt, bei einem Abschirmungs- und Positionierrahmen für solche Leiterplatten in Tauchgalvanikanlagen eine Blende vorzusehen, die wie ein Dachfirst ausgebildet ist und mit seitlichen Lappen in senkrecht verlaufenden Schlitzen einer Halterung geführt ist. Der "First" dieses "Daches" ist nach unten gerichtet. In ihrer Grundstellung befindet sich diese Blende auf der Badoberfläche. Die zu behandelnde Leiterplatte wird mit ihrer unteren Kante von oben in das "Dachinnere" eingesetzt und nimmt die Blende beim Eintauchvorgang nach unten mit. Diese Blende verhindert sogenannte Anbrennungen, d.h. nicht erwünschte zusätzliche Ablagerungen der Metallisierung im unteren Randbereich des vorgenannten Nutzens. Diese vorbekannte Anordnung besitzt mehrere Nachteile. Das Niederdrücken der Blende muß über die zu behandelnde Leiterplatte erfolgen. Solche Platten sind aber oft sehr dünn, so daß sie die zum Niederdrücken erforderlichen Kräfte nicht unbeschadet übertragen können. In einem solchen Fall wölben sich die Leiterplatten unter der Einwirkung der Aufdrückkraft nach außen, was zu Beschädigungen dieser empfindlichen Platten und zu unterschiedlich dicken Niederschlägen auf deren konvexen und konkaven Seite führen kann. Die Anordnung nach DE-PS 37 26 571 beschränkt sich außerdem auf Abblendungen, die im unteren Bereich der zu behandelnden Werkstücke vorgesehen sind. Sie eignet sich dabei für die Behandlung unterschiedlich hoher Leiterplatten. Ihre Anwendung dafür ist jedoch nur möglich, wenn in der vertikalen Richtung jeweils nur eine Leiterplatte vorhanden ist, die zudem an ihrer oberen Kante aufgehängt sein muß, z.B. an Halteklammern.

Ferner ist aus JP 55-145 199 A in Patents abstracts of Japan, Sect. C, Vol. 5 (1981) Nr. 16 (C-41) eine Abblendvorrichtung bekannt, die in ihrem Aufbau vom Prinzip her der DE-PS 3 726 571 entspricht, so daß hierzu auf die vorstehenden Ausführungen verwiesen wird.

Beim Gegenstand von JP 62-116 799 A in Patents abstracts of Japan, Sect. C, Vol. 11 (1987) Nr. 332 (C-455) ist eine Anordnung vorgesehen, bei der zwischen der Anode und dem zu behandelnden Gut ein Rahmen angeordnet ist, der ein Fenster für den Durchtritt der Feldlinien bildet. Dabei ist die Höhe dieses Fensters unveränderlich. Lediglich die Breite des Fensters kann durch Abschirmplatten verändert werden. Diese Abschirmplatten können von den vertikalen Streben des Rahmens entsprechend dem Grad der gewünschten Abschirmung nach innen hin verschoben werden. Wie es aus den weiteren Ausführungen noch hervorgeht, kann Problemstellung und Lösung der vorliegenden Erfindung dieser Literaturstelle nicht entnommen werden.

DE-OS 30 27 751 befasst sich mit einer Vorrichtung zum galvanischen Metallisieren von Substraten und dabei hauptsächlich mit der Anbringung des Substrates bzw. mehrerer Substrate an einer oberen Kontaktschiene. Diese Kontaktschiene kann zwar mit Hilfe einer Schraubverstellung in ihrer Höhenlage eingestellt werden, doch muß dies für jede Höhenlage von Hand durchgeführt werden und zwar durch Lockerung der Verstellung, Bringen der Kontaktschiene in die richtige Lage und wieder Fixieren der vorgenannten Lage. Derartige Handhabungen sind umständlich. Ferner sind Blenden zur teilweisen Abdeckung von Feldlinien vorgesehen, wobei aber diese Blenden nachteiligerweise nicht in ihrer Abblendwirkung dem jeweiligen Werkstück anpaßbar sind. Vielmehr muß für jede Werkstückform und Größe eine geosnderte Blende vorgesehen sein.

Im übrigen erfüllen die beiden letztgenannten Literaturstellen nicht den Oberbegriff des Anspruches 1, sind also gattungsfremd.

Generell ist zur vorliegenden Problematik zu sagen, daß auch der obere Randbereich der Werkstücke zur Vermeidung zu hoher Feldliniendichte in der Regel einer Abblendung bedarf, während an den seitlichen Kanten diese Abblendung entweder die Galvanisiergestelle, oder die Leiterplatten gegenseitig, übernehmen. Im letzteren Fall, wenn die Leiterplatten nur oben gehalten werden, wird an der äußersten linken und der äußersten rechten Kante des "Galvanofensters" eine zu hohe Feldliniendichte dadurch vermieden, daß die Gesamtbreite der Anoden kleiner gehalten wird, als die Gesamtbreite der zu galvanisierenden Fläche. Unter "Galvanofenster" versteht man die Fläche eines in einem Bad hängenden, zu galvanisierenden Gutes, die effektiv genutzt, d.h. galvanisch mit der Metallisierung versehen wird. Die Abblendung des oberen Randbereiches der Werkstücke erfolgt üblicherweise durch Blenden, die entweder an den Halterungen der Werkstücke oder an den Anoden fest angebracht sind. Eine Änderung ihrer Lage ist aufwendig und wird deshalb üblicherweise nicht vorgenommen. Dadurch muß aber die obere Kante der Werkstücke immer in die gleiche Position gebracht werden, was bei stark variierenden Abmessungen nachteilig ist, bzw, oft nicht möglich ist, wenn z.B. schon die untere Kante immer in die gleiche Position gebracht werden muß.

Bei Halterung der Leiterplatten an Gestellstäben müssen diese für die maximale Leiterplattenhöhe ausgelegt sein. Sollen dann kürzere Leiterplatten behandelt werden, drücken diese Gestellstäbe die schwimmende Blende nach unten und der höher liegende Plattenrand wird nicht mehr abgeblendet.

Die Aufgabe bzw. Problemstellung der Erfindung besteht demgegenüber darin, eine Vorrichtung gemäß dem Oberbegriff des Anspruches 1 so auszugestalten, daß die Verstellung der Blende in Vertikalrichtung ohne Rücksicht auf Gestaltung und insbesondere die Stärke des zu behandelnden Werkstückes, sowie dessen Halterung am Warenträger vorgenommen werden kann (es sind also nicht nur Platten, sondern auch Werkstücke behandelbar, wie sie eingangs erläutert wurden), und wobei ferner wahlweise die vorgenannte Blende(n) den unteren oder den oberen Bereich des zu behandelnden Werkstückes bzw. der zu behandelnden Werkstücke abdecken kann, oder auch beide Bereiche.

Die Lösung dieser Aufgabe wird, ausgehend vom Oberbegriff des Anspruches 1, in den Merkmalen des Kennzeichens des Anspruches 1 gesehen. Die Niederdruckkraft zur Verlagerung der Blenden in die gewünschte Vertikal-Position erfolgt durch einen Niederhalter, so daß das zu behandelnde Werkstück bzw. die zu behandelnden Werkstücke (nachstehend wird zur Einfachheit immer nur von "Werkstück" gesprochen, wobei dies aber auch die Fälle von zwei oder mehreren übereinander angeordneten Werkstücken umfaßt) mit der Niederdruckkraft nicht beaufschlagt wird. Gegenüber DE-PS 3726571 ist es von Vorteil, daß in der vertikalen Richtung auch mehrere Werkstücke übereinander behandelt werden können.

Die Blenden für die Beeinflussung der oberen Werkstückkante sind als Schwimmkörper ausgebildet, die nach Wegnahme der Niederdruckkraft und Anheben des Niederhalters von selbst aufgrund ihres Auftriebes die Ausgangsposition einnehmen, in der sie auf der Badoberfläche schwimmen.

Die Blenden für die Beeinflussung der unteren Werkstückkante können entweder ebenfalls als Schwimmkörper, oder so ausgebildet sein, daß sie in der Behandlungslösung nach unten sinken. Durch entsprechend ausgebildete Niederhalter werden sie im ersteren Fall nach unten gedrückt, wenn der Warenträger in die Behandlungsstation abgelegt wird, im letzteren Fall in die erforderliche Höhenlage gezogen.

Sowohl die oberen, wie auch die unteren Blenden sind an ihren jeweiligen Enden am Badbehälter in Vertikalrichtung beweglich geführt. Es kann sowohl der obere Bereich als auch der untere Bereich der zu behandelnden Werkstücke abgeblendet werden, wobei der Niederhalter jeweils auf die Blenden einwirkt, d.h. sie in Vertikalrichtung so verstellt, daß ihre Höhenlage der Höhenlage des entsprechenden Kantenbereiches des Werkstückes angepaßt wird.

Es ist dabei möglich, z.B. an der Beladestation beim Beschicken der Anlage, eine von der Bedienungsperson vorwählbare Anpassung der Blendenposition durch Einstellen des Niederhalters entweder für die obere oder die untere Werkstückkante vorzunehmen. Die jeweils andere Blende kann an der Behandlungsstation fest eingestellt sein, wenn die dazugehörige Werkstückkante immer in die gleiche Lage gebracht wird. Mit der erfindungsgemäßen Lösung sind aber auch Änderungen der Höhenlage der fest eingestellten Blende leicht möglich, wenn dies z.B. durch eine andere Art der Werkstücke erforderlich ist.

Die Erfindung ist sowohl im Fall des Anhängens der zu galvanisierenden Werkstücke (insbesondere ist dabei an elektronische Leiterplatten gedacht) mittels Klammern oder dergleichen an den Warenträger, oder auch bei solchen Anordnungen einsetzbar, bei denen die zu behandelnden Werkstücke sich an Traggestellen befinden, die ihrerseits am Warenträger angebracht sind.

Weitere Merkmale der Erfindung sind den Unteransprüchen zu entnehmen.

In der nachfolgenden Beschreibung und der zugehörigen Zeichnung von erfindungsgemäßen Ausführungsmöglichkeiten sind weitere Einzelheiten und Vorteile erläutert. In der Zeichnung zeigt:
- Fig. 1:: eine Vorrichtung nach der Erfindung in einem Galvanikbad, und zwar im Querschnitt
- Fig. 2:: einen Schnitt gemäß der Linie II-II in Fig. 1
- Fig. 3:: eine teilweise Seitenansicht gemäß der Linie III-III in Fig. 1
- Fig. 4:: schematisch eine Ansicht des Bades mit Vorrichtung nach der Erfindung gem. Fig. 3, wobei das Bad vollständig im entsprechenden Schnitt dargestellt ist
- Fig. 5 bis 5c:: im vergrößerten Maßstab die Verstellung des Niederhalters zum Warenträger in verschiedenen Ansichten und Positionen
- Fig. 6:: eine Ausbildung der Abblendung nach der Erfindung in der Seitenansicht
- Fig. 6a:: die Abblendung nach Fig. 6 in angehobener Stellung
- Fig. 7:: einen Schnitt gemäß der Linie VII-VII in Fig. 6
- Fig. 8:: einen Schnitt analog Fig. 7, jedoch in einer anderen Stellage der Abblendung
- Fig. 9:: eine teilweise Seitenansicht gemäß Fig. 3 jeoch mit einer anderen Ausführungsform
- Fig. 10:: eine teilweise Seitenansicht gemäß Fig. 3

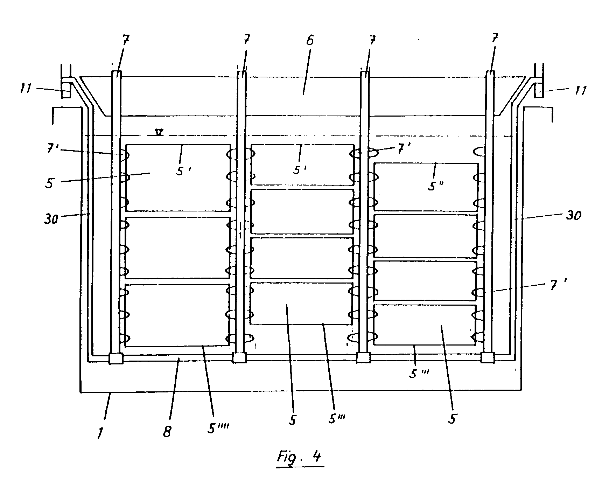

Im Badbehälter 1 befinden sich die Anoden 2, von denen über Diaphragmaschirme 3 das elektrische Feld in der Richtung 4 zu den zu galvanisierenden Werkstücken, hier elektronische Leiterplatten 5, fließt. Es ist ein Warenträger 6 vorgesehen, an dem die Werkstücke 5 entweder angeklammert oder gemäß dem vorliegenden Ausführungsbeispiel über Traggestelle 7 gehalten sind, zwischen und an denen mittels Halteklammern oder dergleichen 7' die Werkstücke 5 befestigt werden (siehe auch Fig. 4). Solche Traganordnungen sind an sich bekannt. Die Warenträger mit den daran hängenden Werkstücken werden mittels hier nicht dargestellter, da ebenfalls bekannter Mittel wie Transportwagen über das jeweilige Bad gebracht, darin abgesenkt, behandelt und dann weiter transportiert.

Auf einem rohrförmigen Mitnahmebügel 8 sitzt der Warenträger 6 über das Traggestell 7 mit zwei nach außen ragenden Blechen 9 in einer Art "Reitersitz" auf. Der Mitnahmebügel 8 wird in Richtung der Doppelpfeile 10 hin und her bewegt, z.B. um 35 - 40 mm, und zwar mit Hilfe eines Rohres 11, auf das der Warenträger über - nicht dargestellte - Einweisungen abgelegt ist und das entsprechend hin und her bewegt wird. Hiermit wird die Ware im Bad entsprechend bewegt. Der Mitnahmebügel 8 ist über die Arme 30 mit dem Rohr 11 verbunden.

Insbesondere Fig. 4 zeigt, daß die Höhenlage der zu behandelnden Werkstücke im Bad unterschiedlich sein kann. So zeigt Fig. 4 links, daß sich die Werkstücke 5 über die gesamte Höhe der Traggestelle erstrecken. In der Mitte von Fig. 4 ist die Bestückung der Traggestelle mit Werkstücken kleinerer Höhenabmessungen dargestellt. Die obere Werkstückkante 5' liegt dabei auf gleicher Höhe wie bei der Anordnung auf der linken Seite, doch die unterste Kante 5''' liegt höher als die unterste Kante 5'''' in Fig. 4 links.

Auf der rechten Seite von Fig. 4 sind die Traggestelle mit Werkstücken gleicher Art wie in der Mitte bestückt, nur daß die Anordnung so gewählt wurde, daß die untere Werkstückkante 5''' auf gleicher Höhe liegt, wie in der linken Darstellung die Kante 5'''', die obere Werkstückkante 5'' liegt tiefer als die Kanten 5'.

Ob dabei immer die gleiche obere oder die gleiche untere Höhe der Werkstückkanten angestrebt wird, hängt von der Art der Traggestelle ab und davon, wie das Anbringen der Werkstücke an den Traggestellen erfolgt (von Hand / automatisch). Selbstverständlich müssen dabei an einem Warenträger alle oberen und unteren Werkstückkanten jeweils in gleicher Höhenlage sein.

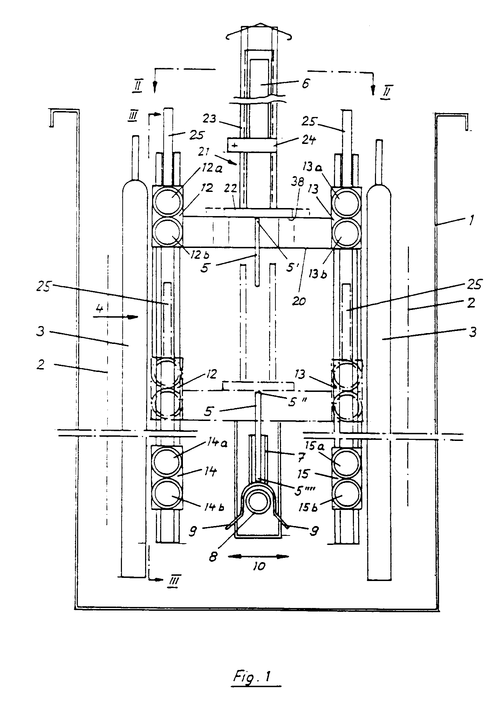

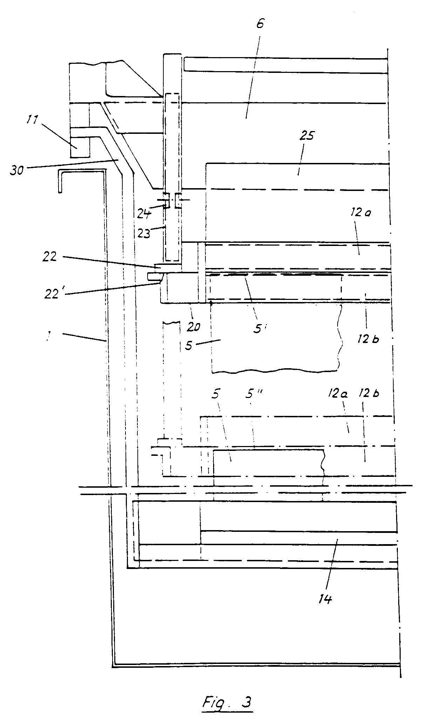

Die jeweils oberen und unteren waagerechten Kanten bzw. die dazugehörigen Bereiche der Werkstücke und auch angrenzende Gestellteile sollen davor geschützt werden, daß sich an ihnen aufgrund einer Konzentration der Feldlinien 4 in unerwünschter Weise zu viel Metall beim Galvanisiervorgang absetzt. Um dies zu verhindern, sind die nachstehend noch näher zu erläuternden Blenden vorgesehen. Fig. 1 zeigt hierzu zwei Stellungen eines Werkstückes 5, wobei in der oberen Stellung die obere Kante mit 5' beziffert ist. Eine demgegenüber andere, untere Stellung ist ebenfalls eingezeichnet, und zwar mit einer oberen Kante 5'' des Werkstückes 5. Die vorgenannten Positionen sind auch in Fig. 3 angedeutet.

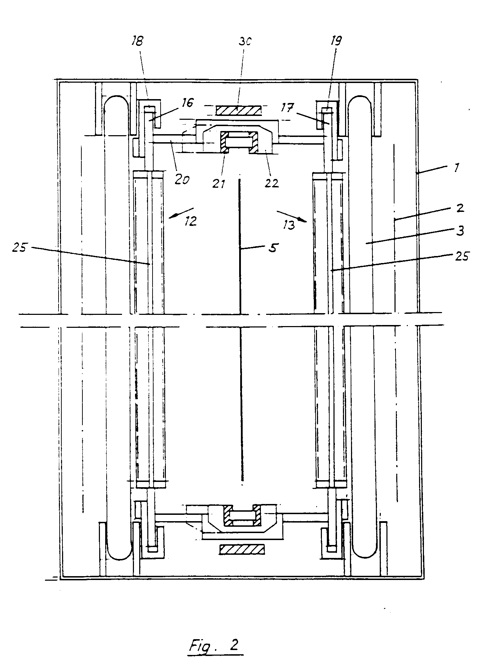

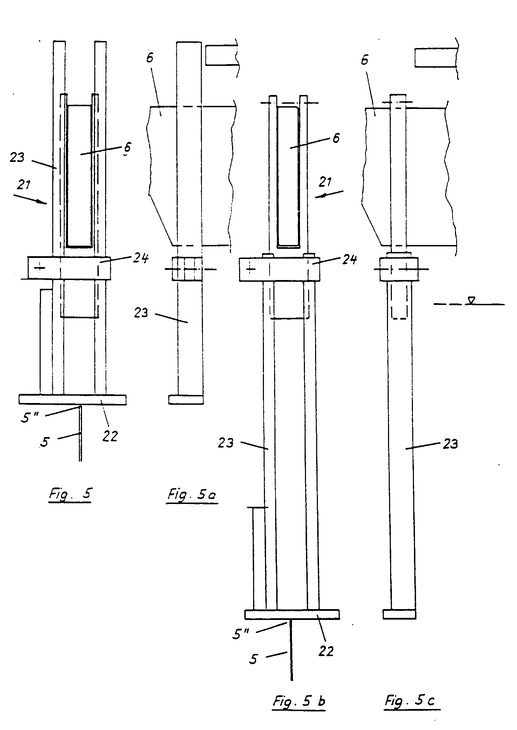

Im Beispiel der Fig. 1 sind für die Abblendung der oberen Werkstückkanten 5' bzw. 5'' Schwimmkörper zu beiden Seiten der zu behandelnden Waren, d.h. in der Darstellung gem. Fig. 1 links und rechts davon vorgesehen. Bevorzugt ist ein oberes Paar 12, 13 an Schwimmkörpern vorgesehen, wobei das Paar aus zwei Schwimmkörpern 12a, 12b und 13a, 13b besteht. Die Schwimmkörper sind in sich geschlossen, z.B. beidseitig abgeschlossene Rohrstücke. Die zueinander gehörenden Schwimmkörper sind miteinander fest verbunden, z.B. verschweißt. An den Enden besitzen die Schwimmkörper bzw. Schwimmkörperanordnungen Führungslaschen 16, 17, die in senkrecht verlaufenden Schlitzführungen 18, 19 des Badbehälters 1 gleitend geführt sind (siehe insbesondere Fig. 2). Die Führungslaschen 16, 17 jeder Seite sind durch ein strebenartiges Teil oder eine Strebe 20 miteinander verbunden. Auf diese Strebe kann ein Niederhalter 21 mit einem z.B. als Platte ausgebildeten Widerlager 22 zur Auflage kommen. Dieser Niederhalter ist mit seinem Schaft 23 höhenbeweglich am Warenträger 6 gleitend geführt, wobei die jeweils gewünschte Höhenlage mittels einer Klemmschelle oder dergleichen 24 fixierbar ist. Die Schwimmkörper bzw. Schwimmkörperpaare (hier das obere Paar 12, 13) schwimmen aufgrund ihrer in vertikaler Richtung frei gleitenden Führung auf der Oberfläche des Bades, die nicht dargestellt ist. Sie werden beim Ablegen des Warenträgers 6 in die Behandlungsstation durch den Niederhalter in die Höhenlage gebracht und dort gehalten, in der sie eine Verringerung bzw. teilweise Abschirmung der Feldlinien bewirken sollen, die auf den betreffenden Bereich des zu behandelnden Werkstückes einwirken. Dies ist in Fig. 1 in zwei unterschiedlichen Positionen dargestellt. In der oberen, mit durchgezogenen Linien dargestellten Lage schirmen die Schwimmkörper 12, 13 die obere Kante bzw. Bereich 5' ab (siehe Fig. 5 und 5a), während in der unteren, gestrichelt dargestellten Lage sich der Niederhalter tiefer befindet und damit die Schwimmkörperpaare 12, 13 entsprechend weit nach unten gedrückt hat, so daß sie die nun tiefer liegende obere Werkstückkante bzw. -bereich 5'' abschirmen (siehe auch Fig. 5b und 5c). Die Badhöhe ist in beiden Fällen die gleiche geblieben. Die erstgenannte Variante entspricht Fig. 4 links und Mitte und die zweitgenannte Variante Fig. 4 rechts. Die Kontaktberührung, welche das Widerlager 22 des Nlederhalters 21 beim Ablegen des Warenträgers in die Behandlungsstation mit der Strebe 20 bekommt, dient der Festlegung der hier notwendigen Positionierung der jeweiligen Schwimmkörper. Zweckmäßigerweise wird die Einrichtung so gestaltet, daß die Unterkante 38 des Widerlagers 22 auf gleiche Höhe eingestellt werden kann, wie die obere Kante 5' bzw. 5'' der Werkstücke 5. Dadurch ist dem Bedienungspersonal beim Beschicken der Anlage eine leichte Einstellung möglich. Der Arbeitsdruck des Niederhalters 21 wird aber ausschließlich über die gem. Fig. 2 seitlich im Abstand neben dem Werkstück befindliche Strebe 20 auf die Schwimmkörper übertragen. Fig. 1 zeigt, daß die jeweiligen oberen Kanten 5' bzw. 5'' der Werkstücke sich in der Mitte zwischen den beiden Schwimmkörpern 12a bzw. 12b u.s.w. eines Schwimmkörpers befinden und daher sowohl der Werkstückbereich unterhalb der jeweiligen Kante als auch der Gestellbereich oberhalb der jeweiligen Kante entsprechend abgeschirmt ist.

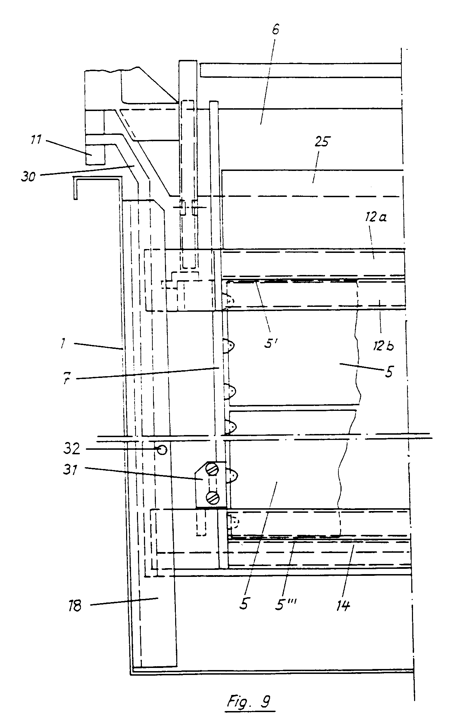

Um zusätzlich zu einer oberen Abschirmung, wie vorstehend erläutert, eine Abschirmung auch eines unten gelegenen Bereiches eines Werkstückes zu sichern, ist ferner in Fig. 1 ein Blendenpaar 14, 15 vorgesehen, das analog den Schwimmkörperpaaren 12, 13 aufgebaut ist. Dieses Blendenpaar kann entweder auch als Schwimmkörper ausgebildet sein, oder als Körper, dessen spezifisches Gewicht größer ist als das der Behandlungsflüssigkeit. In Anlagen, bei denen die untere Werkstückkante 5'''' immer auf etwa der gleichen Höhe angeordnet ist, wird man die Lage des Blendenpaares 14, 15 z.B. mittels einer (nicht dargestellten) Schraubverbindung fixieren, wobei man aber die Halterung zweckmäßigerweise bis über den Badspiegel führt, um auch nachträglich leicht eine Höhenkorrektur vornehmen zu können. Möglich ist es jedoch auch, bei Ausbildung des Blendenpaares 14, 15 als Schwimmkörper, diese durch einen beispielsweise an den äußeren Gestellstäben 7 angebrachten Niederhalter 31 in eine gewünschte Position zu bewegen, wobei die maximale Höhenlage durch einen Anschlag 32 begrenzt wird, damit nicht eine Kollision mit dem oberen Blendenpaar 12, 13 erfolgt (siehe Fig. 9).

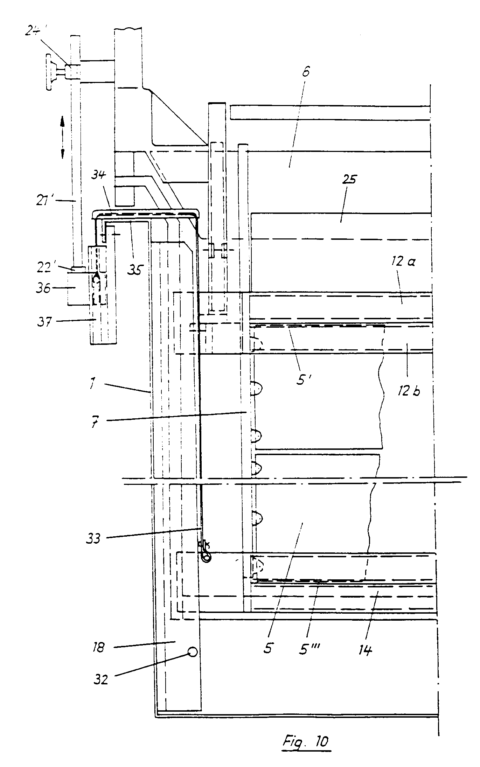

Die vorgenannte Ausführungsform, das untere Blendenpaar 14, 15 als Körper auszubilden, dessen spezifisches Gewicht größer ist als das der Behandlungsflüssigkeit und die beim Ablegen des Warenträgers 6 in die Behandlungsstation in eine gewünschte Position bewegt werden, ist in Fig. 10 dargestellt. Der Blendenkörper 14 - wie auch 15 - ist hierbei z.B. an einem flexiblen Band 33 aufgehängt, das über eine Umlenkeinrichtung 34 über den Behälterrand 35 zu einem Gleitstück 36 geführt und dort befestigt ist. Das Gleitstück 36 ist in einem Führungsteil 37 in der Vertikalen auf und ab beweglich.

Beim Ablegen des Warenträgers 6 in der Behandlungsstation drückt ein nun außen an ihm angebrachter Niederhalter 21' mit seinem Widerlager 22' auf das Gleitstück 36 und drückt dieses nach unten, wobei über das Band 33 der Blendenkörper 14 nach oben gezogen wird. Der Niederhalter 21' ist über eine Klemmvorrichtung 24' in die Höhe einstellbar, wodurch eine Lage gewählt werden kann, welche den Blendenkörper 14 in die gewünschte Position zum Abblenden der unteren Werkstückkante 5''' bringt. In diesem Fall drück der Niederhalter nicht direkt auf die Blendenkörper 14, 15, sondern auf das o.g. Gleitstück 36, wodurch ebenfalls, wie erläutert, die Höhenlage der Blendenkörper eingestellt wird. Im Ergebnis bewirkt also der Niederhalter auch hier die Bewegung der Blenden in die vorgewählte Position.

Die tiefste Lage des Blendenkörpers 14 wird, wenn die Behandlungsstation nicht mit einem Warenträger 6 belegt ist, durch den Anschlag 32 begrenzt.

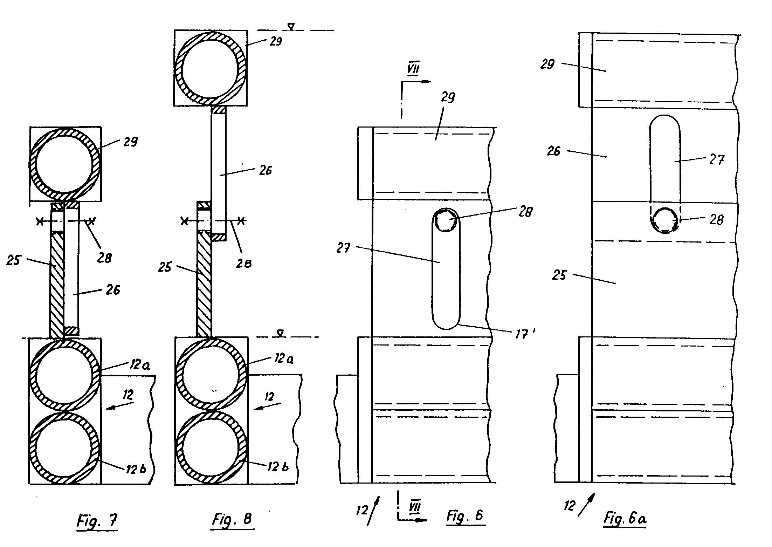

Der Aufbau der Schwimmkörper aus zwei übereinander liegenden Rohren oder dergleichen ergibt den Vorteil, daß man ein relativ großes Schwimmkörpervolumen bei relativ geringer Breite hat. An den jeweiligen oberen Schwimmkörperpaaren können zusätzliche Abblendungen 25 vorgesehen sein, die sich von ihrer Anbringungsstelle senkrecht nach oben erstrecken. Sie haben den Zweck, bei einer Position dieser Schwimmkörperpaare relativ tief unterhalb der Badhöhe (z.B. wie in Fig. 1 gestrichelt dargestellt) die darüber vorgesehenen und sich noch im Bad befindlichen Teile des Traggestelles 7 gegen unerwünschte Ablagerungen der Metallisierung des Bades abzuschirmen. Diese Abschirmwirkung kann räumlich in der Vertikalen noch durch eine weitere Ausführung der Erfindung vergrößert werden, die in den Figuren 6 - 8 dargestellt ist. Dort sei wieder der Schwimmkörper 12 aus den beiden Rohren 12a, 12b betrachtet. Am oberen Rohr 12a befindet sich eine Abdeckung 25. Hiermit ist eine weitere Abdeckung 26 in der Vertikalen gleitend verbunden, und zwar mittels vertikal verlaufender Schlitze 27 in der einen Abdeckung 26 und darin eingreifenden Bolzen oder dergleichen 28 der anderen Abdeckung 25. An der oberen Abdeckung 26 ist ein weiterer geschlossener Schwimmkörper 29 angebracht, der sich über der Badoberfläche befindet, solange der untere Schwimmkörper 12 auf der Badoberfläche schwimmt, oder vom Niederhalter 21 nur wenig in das Bad gedrückt wird. Erst bei tieferen Einstellungen des Niederhalters 21 schwimmt der Schwimmkörper 29 auf der Badoberfläche und zieht dadurch den Blendenkörper auseinander, d.h. aus der abgesenkten Position gem. Fig. 6 in die angehobene Position gem. Fig. 6a, womit die Höhe der Abdeckung praktisch verdoppelt ist. Hierdurch wird der Spielraum in der Vertikalen zur Schaffung einer Abdeckung der Traggestelle wesentlich erweitert.

Mit der Erfindung ist also eine beliebige Anpassung der Abschirmungen sowohl an den jeweiligen oberen Bereichen der Werkstücke als auch an den jeweiligen unteren Bereichen der Werkstücke möglich, und zwar sowohl bei Halt der Werkstücke mittels Traggestellen als auch bei Halt der Werkstücke direkt an den Warenträgern mittels Klammern. Die letztgenannte Möglichkeit ist im Ausführungsbeispiel zeichnerisch nicht dargestellt, jedoch ist dabei ebenso die Verschiebung der Höhenlage der Schwimmkörper bzw. Abblendungen analog dem zuvor erläuterten Ausführungsbeispiel durchführbar.

## Patentansprüche

1. Vorrichtung zum Abblenden von Feldlinien in einer Galvanikanlage zur Behandlung von im wesentlichen plattenförmigen Werkstücken, die an einem Warenträger hängend in ein Bad eingebracht werden, wobei eine in Vertikalrichtung verstellbar am Badbehälter geführte Blende vorgesehen ist, dadurch gekennzeichnet, daß am Warenträger (6) ein Niederhalter (21, 31, 21') höhenverstellbar und in der jeweiligen Stellage fixierbar (24, 24') angebracht ist, der die seitlich der zu galvanisierenden Werkstücke (5) angeordneten Blenden (12, 13; 14, 15) beim Einbringen des Warenträgers (6) in die Behandlungsstation (1) in eine vorgewählte Position bewegt.

2. Vorrichtung nach Anspruch 1, dadurch gekennzeichnet, daß die Blenden als Schwimmkörper (12, 13; 14, 15) ausgebildet sind, die vom Niederhalter (21; 31) entgegen ihren Auftrieb in die Behandlungsflüssigkeit gedrückt werden.

3. Vorrichtung nach Anspruch 2, dadurch gekennzeichnet, daß die sich gegenüber liegenden Blenden (12, 13), die sich seitlich im Abstand neben dem Werkstück (5) befinden, über zumindest ein strebenartiges Teil (20) miteinander verbunden sind, und daß das Widerlager (22) des Niederhalters (21) zur Auflage auf das strebenartige Teil oder die strebenartigen Teile (20) ausgebildet und positioniert ist.

4. Vorrichtung nach Anspruch 1, dadurch gekennzeichnet, daß die Blenden als Körper (14, 15) ausgebildet sind, deren Gewicht größer ist als das Gewicht der von ihnen verdrängten Behandlungsflüssigkeit.

5. Vorrichtung nach Anspruch 4, dadurch gekennzeichnet, daß die Blenden (14, 15) vom Niederhalter (21') über ein Band (33), das über eine Umlenkeinrichtung (34) geführt ist, in eine gewünschte Höhenlage bewegt werden.

6. Vorrichtung nach einem der Ansprüche 1 bis 5, dadurch gekennzeichnet, daß zwei Paar Blenden (12, 13; 14, 15) vorgesehen sind, wobei ein Paar (12, 13) zur Abblendung der jeweils zuoberst (5', 5'') gelegenen und das andere Paar (14, 15) zum Abblenden der jeweils zuunterst (5'''') gelegenen waagerechten Kante des Werkstückes oder der Werkstücke (5) ausgebildet ist, und daß die Höhenlage eines der Paare mittels des Niederhalters (21) positioniert ist, während das andere Paar fix gegenüber dem Badbehälter (1) gelagert ist, wobei gegebenenfalls diese Fixlagerung durch Stellmittel in ihrer Höhenlage veränderbar ist.

7. Vorrichtung nach einem der Ansprüche 1 bis 6, dadurch gekennzeichnet, daß zumindest die vom Niederhalter (21) in ihrer Höhenlage zu positionierenden Blenden (12, 13) aus zwei übereinander liegenden rohrförmigen und an ihren Stirnenden abgeschlossenen Schwimmkörpern (12a, 12b, 13a, 13b) bestehen.

8. Vorrichtung nach einem der Ansprüche 1 bis 3 und 6, 7, dadurch gekennzeichnet, daß an der, jeweils oben gelegenen Blenden- bzw. Schwimmkörperanordnung sich eine in der Vertikalen nach oben erstreckende Abdeckung (25) befindet, die zur Abblendung des dort befindlichen Bereiches eines Traggestelles (7) dient und bevorzugt plattenförmig ausgebildet ist.

9. Vorrichtung nach Anspruch 8, dadurch gekennzeichnet, daß die Abdeckungen (25), die sich von der Oberseite der jeweils oberen Blenden (12, 13) nach oben erstrecken, mit einer weiteren, zu ihr verschiebbaren, ebenfalls in Vertikalrichtung verlaufenden Abdeckung (26) verbunden sind, wobei die letztgenannte Abdeckung (26) oberseitig einen Schwimmkörper (29) trägt und die Verschiebemittel zwischen dieser und der erstgenannten Abdeckung (25) in vertikaler Richtung verlaufen.

10. Vorrichtung nach Anspruch 9, dadurch gekennzeichnet, daß die eine Abdeckung (26) in vertikaler Richtung verlaufende Schlitze (27) und die andere Abdeckung (25) in die Schlitze eingreifende Anschläge oder Bolzen (28) aufweist, die in den Schlitzen gleiten

## Claims

1. Apparatus for screening lines of electrical flux in an electroplating system for the treatment of substantially plate-like workpieces which are introduced into a bath while suspended from a workpiece carrier, a screen being provided, which is adjustably guided on the bath in the vertical direction, characterised in that a hold-down device (21, 31, 21') is mounted on the workpiece carrier (6) so as to be vertically adjustable and securable (at 24, 24') in the respective adjustment position, said hold-down device moving the screens (12, 13; 14, 15), which are disposed laterally of the workpieces (5) to be electroplated, into a preselected position when the workpiece carrier (6) is introduced into the treatment station (1).

2. Apparatus according to claim 1, characterised in that the screens are configured as floats (12, 13; 14, 15), which are forced into the treatment fluid by the hold-down device (21; 31) in opposition to their buoyancy.

3. Apparatus according to claim 2, characterised in that the screens (12, 13), which lie opposite each other and are situated laterally adjacent the workpiece (5) with a spacing therebetween, are interconnected via at least one bar-like member (20), and in that the support (22) for the hold-down device (21) is configured and positioned so as to rest upon the bar-like member or the bar-like members (20).

4. Apparatus according to claim 1, characterised in that the screens are configured as bodies (14, 15), the weight of which is greater than the weight of the treatment fluid displaced thereby.

5. Apparatus according to claim 4, characterised in that the screens (14, 15) are moved into a desired vertical position by the hold-down device (21') via a belt (33), which is guided by a guide means (34).

6. Apparatus according to one of claims 1 to 5, characterised in that two pairs of screens (12, 13; 14, 15) are provided, one pair (12, 13) being configured to screen the uppermost horizontal edge (5', 5'') of the workpiece or workpieces (5), and the other pair (14, 15) being configured to screen the lowermost horizontal edge (5'''') of the workpiece or workpieces (5), and in that the vertical position of one of the pairs is positioned by means of the hold-down device (21), while the other pair is fixedly mounted relative to the bath (1), this fixed mounting possibly being variable in respect of its vertical position by adjustment means.

7. Apparatus according to one of claims 1 to 6, characterised in that at least the screens (12, 13), which are to be positioned in their vertical position by the hold-down device (21), comprise two tubular floats (12a, 12b, 13a, 13b), which are situated above each other and are sealed at their front ends.

8. Apparatus according to one of claims 1 to 3 and 6, 7, characterised in that a covering (25), which extends upwardly in the vertical, is situated on the upper arrangement of screens or floats, said covering serving to screen the region of a supporting structure (7) situated there and preferably having a plate-like configuration.

9. Apparatus according to claim 8, characterised in that the coverings (25), which extend upwardly from the upper surface of the respective upper screens (12, 13), are connected to an additional covering (26), which is displaceable relative thereto and also extends in the vertical direction, the last-mentioned covering (26) being provided at its upper end with a float (29), and the displacement means extending in the vertical direction between the latter covering and the first-mentioned covering (25).

10. Apparatus according to claim 9, characterised in that one covering (26) has slots (27) extending in the vertical direction, and the other covering (25) has stop members or bolts (28), which engage in the slots and slide in the slots.

## Revendications

1. Dispositif de blindage des lignes de champ dans une installation de galvanisation pour le traitement de pièces sensiblement en forme de plaques, qui, suspendues à un support de pièces, sont plongées dans un bain dans lequel il est prévu un écran guidé sur la cuve, réglable verticalement, caractérisé en ce qu'un dispositif de maintien en position basse (21, 31, 21'), qui place les écrans (12, 13 ; 14, 15) disposés latéralement par rapport aux pièces (5) à galvaniser dans une position préalablement choisie lors de la mise en place du support de pièces (6) sur le poste de traitement (1), est monté réglable en hauteur et pouvant être fixé dans ladite position (24, 24'), sur le support de pièces (6).

2. Dispositif selon la revendication 1, caractérisé en ce que les écrans sont conformés comme des flotteurs (12, 13; 14, 15), qui sont poussés dans le liquide de traitement, par le dispositif de maintien en position basse (21 ; 31), dans le sens opposé à la poussée verticale qu'ils exercent.

3. Dispositif selon la revendication 2, caractérisé en ce que les écrans (12, 13) se faisant face, qui se situent latéralement à distance, à côté de la pièce (5), sont reliés l'un à l'autre par au moins une pièce (20) en forme de traverse et en ce que la butée (22) du dispositif de maintien en position basse (21) est conformée et positionnée pour prendre appui sur la pièce en forme de traverse ou les pièces en forme de traverse (20).

4. Dispositif selon la revendication 1, caractérisé en ce que les écrans sont conformés comme des corps (14, 15), dont le poids est supérieur à celui du liquide de traitement qu'ils déplacent.

5. Dispositif selon la revendication 4, caractérisé en ce que les écrans (14, 15) sont amenés dans la position en hauteur désirée, par le dispositif de maintien en position basse (21'), par l'intermédiaire d'une courroie (33) qui est guidée par un dispositif de renvoi (34).

6. Dispositif selon l'une quelconque des revendications 1 à 5, caractérisé en ce que deux paires d'écrans (12, 13 ; 14, 15) sont prévues, une paire (12, 13) étant conformée respectivement pour le blindage du bord horizontal le plus haut (5',5'') et l'autre paire (14, 15) pour blinder le bord horizontal le plus bas (5'''') de la pièce ou des pièces (5), et en ce que la position en hauteur de l'une des paires est déterminée au moyen du dispositif de maintien en position basse (21), alors que l'autre paire est supportée fixe, par rapport à la cuve (1), la position en hauteur de ce support fixe pouvant être le cas échéant modifiée par l'intermédiaire de moyens de réglage.

7. Dispositif selon l'une quelconque des revendications 1 à 6, caractérisé en ce qu'au moins les écrans (12, 13) devant être positionnés en hauteur par le dispositif de maintien en position basse (21) sont constitués de deux flotteurs (12a, 12b, 13a, 13b) de forme tubulaire superposés l'un à l'autre et dont les extrémités frontales sont obturées.

8. Dispositif selon l'une quelconque des revendications 1 à 3 et 6, 7, caractérisé en ce que qu'un cache (25) s'étendant vers le haut, dans le sens vertical, est placé sur le dispositif à écrans ou flotteur situé en haut, ledit cache servant à blinder la zone, située à cet endroit, d'une structure de support (7) et étant de préférence conformé comme une plaque.

9. Dispositif selon la revendication 8, caractérisé en ce que les caches (25), qui s'étendent respectivement vers le haut à partir du côté supérieur des écrans supérieurs (12, 13) sont reliés à un autre cache (26) s'étendant également dans le sens vertical, et pouvant être déplacé en translation par rapport audit cache (25), le cache (26) mentionné en dernier lieu comportant en partie haute un flotteur (29) et les moyens de translation entre le cache (26) et le cache (25) s'étendant dans le sens vertical.

10. Dispositif selon la revendication 9, caractérisé en ce que le cache (26) présente des fentes (27) s'étendant dans le sens vertical et l'autre cache (25) des taquets ou boulons (28) qui glissent dans les fentes venant en prise dans lesdites fentes.
